# EUROPEAN PATENT APPLICATION

(11) **EP 4 711 426 A1**
(43) Date of publication of application: **18.03.2026**
(21) Application number: 24803244.3
(22) Date of filing: 24.01.2024
(51) Int. Cl.: C09D 11/36, B41J 2/01, B41M 5/00, C09D 11/101, H05K 3/28

(54) **ACTIVE RAY-CURABLE INKJET INK COMPOSITION, METHOD FOR FORMING INSULATING FILM, INSULATING FILM, AND PRINTED WIRING BOARD**

(30) Priority: 09.05.2023 JP 2023077161
(71) Applicant: KONICA MINOLTA, INC., Tokyo 100-7015 (JP)
(72) Inventor: KAWANAMI, Tomoe, Tokyo 100-7015 (JP); AOYAMA, Ryo, Tokyo 100-7015 (JP); TANI, Kunio, Tokyo 100-7015 (JP); TANAKA, Kyohei, Tokyo 100-7015 (JP)
(74) Representative: Gille Hrabal Partnerschaftsgesellschaft mbB Patentanwälte
(86) International application number: PCT/JP2024/001986
(87) International publication number: WO 2024/232129

(57) **Abstract**

The present invention relates to an active ray-curable inkjet ink composition that can form an insulating film having sufficiently increased adhesiveness with metal surfaces of electronic components and that can form an insulating film the insulating property of which does not tend to decline in a high-humidity environment, a method for forming an insulating film, an insulating film, and a printed wiring board. Provided is an active ray-curable inkjet ink composition containing an active ray-polymerizable compound, wherein the active ray-polymerizable compound contains a carboxyl group-free amine-modified oligomer and an active ray-polymerizable compound having a carboxyl group, and the active ray-curable inkjet ink composition is used to form an insulating film for an electronic component.

## Description

### Technical Field

The present invention relates to an active ray curable inkjet ink composition, a method for forming an insulating film, an insulating film, and a printed wiring board.

### Background of the invention

As an inkjet ink, an active ray curable ink containing an active ray polymerizable compound is known. When the active ray curable ink is irradiated with active rays, the active ray curable ink can form a cured film by being cured by polymerization of the active ray polymerizable compound. The active ray curable inkjet ink can be used for forming an insulating film on an electronic member in a field other than the printing field. The insulating film covers the surface of a metal portion (through which, a current flows) of the electronic member, and suppresses a short circuit or the like between electrodes.

As an ink for forming such an insulating film, for example, PTL 1 discloses a curable composition for inkjet including the following: a polyfunctional compound having two or more (meth)acryloyl groups in the molecule, a photopolymerization initiator, and a compound having a cyclic ether group, in which the photopolymerization initiator has a molecular weight of 500 or more and 1500 or less. It is described in PTL 1 that a cured product obtained by curing the composition has satisfactory heat resistance and insulating properties after a humidification test.

In addition, PTL 2 discloses a photosensitive resin composition for inkjet including (A) a (meth)acrylic compound having a weight-average molecular weight of 500 or more; (B) a (meth)acrylic compound having a weight-average molecular weight of less than 500; (C) a phosphorus-containing flame retardant; (D) an amine-modified (meth)acrylic compound; and (E) a photopolymerization initiator. PTL 2 states that a cured product obtained by curing the above-described composition has excellent flame retardancy and gold plating resistance without degrading insulating properties.

### Citation List

### Patent Literatures

PTL 1 Japanese Unexamined Patent Publication No. 2012-087298
PTL 2 Japanese Unexamined Patent Publication No. 2022-052593

### Summary of Invention

### Technical Problem

As in PTL 1 and PTL 2, an active ray curable inkjet ink composition that can form an insulating film having excellent insulating properties is known.

An ink for forming an insulating film on an electronic member is required to have high adhesion so that the insulating film does not peel off from the metal surface. However, the insulating films formed from the active ray curable inkjet ink compositions described in PTL 1 and PTL 2 do not have sufficiently high adhesion.

Furthermore, it is known that in a high-humidity environment, when a voltage is applied to an electronic member on which an insulating film has been formed, ion migration occurs, resulting in insulation failure. Therefore, there is a demand for an ink composition for forming an insulating film capable of suppressing a decrease in insulating properties even under a high-humidity environment.

The present invention has been made in view of the above-mentioned problems, and an object of the present invention is to provide an active ray curable inkjet ink composition capable of forming an insulating film having sufficiently enhanced adhesion to a metal surface of an electronic member and capable of forming an insulating film whose insulating properties are less likely to decrease under a high-humidity environment, a method for forming an insulating film, an insulating film, and a printed wiring board.

### Solution to Problem

An aspect of the present invention for achieving the above-described object relates to the following active ray curable inkjet ink compositions in [1] to [13].
[1] An active ray curable inkjet ink composition containing active ray polymerizable compound, in which:
   the active ray polymerizable compound includes an active ray polymerizable compound that has a carboxyl group and an amine-modified oligomer that has no carboxyl group; and
   the active ray curable inkjet ink composition is used for forming an insulating film on an electronic member.
[2] The active ray curable inkjet ink composition according to [1], further including a gelling agent.
[3] The active ray curable inkjet ink composition according to [1] or [2], in which the polymerizable compound having a carboxyl group is a compound represented by a general formula (1). 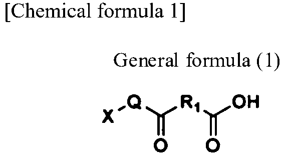 In the general formula (1), R₁ represents an unsubstituted alkylene group having 1 or more and 6 or less carbon atoms, Q represents an oxygen atom or NR₂, R₂ represents a hydrogen atom, a substituted or unsubstituted alkyl group, or a substituted or unsubstituted aryl group, X represents a structure derived from an alcohol or an amine, and X has, at a terminal thereof, at least one polymerizable group selected from the group consisting of a (meth)acryloyl group, an aryl group, and a vinyl group.
[4] The active ray curable inkjet ink composition according to [3], in which, in the general formula (1), X has a (meth)acryloyl group at a terminal thereof.
[5] The active ray curable inkjet ink composition according to [3] or [4], in which in the general formula (1), Q represents an oxygen atom.
[6] The active ray curable inkjet ink composition according to any one of [3] to [5], in which in the general formula (1), R¹ represents an unsubstituted alkylene group having 1 or 2 carbon atoms.
   Furthermore, another aspect of the present invention for achieving the above-described object relates to the following methods for forming an insulating film in [7] and [8].
[7] A method for forming an insulating film, the method including:
   applying the active ray curable inkjet ink composition according to any one of [1] to [6] to an electronic member; and
   irradiating the applied active ray curable inkjet ink composition with an active ray to cure the active ray curable inkjet ink composition.
[8] The method according to [7], further including heating the active ray curable inkjet ink composition having been irradiated with the active ray.
   Further, another aspect of the present invention for achieving the above object relates to the following insulating film in [9].
[9] An insulating film formed by irradiating the active ray curable inkjet ink composition according to any one of [1] to [6] with an active ray.
   Another aspect of the present invention for achieving the above-described object relates to the following printed wiring board in [10].
[10] A printed wiring board comprising the insulating film according to [9].

### Advantageous Effects of Invention

The present invention can provide an active ray curable inkjet ink composition capable of forming an insulating film having sufficiently enhanced adhesion to a metal surface of an electronic member, and capable of forming an insulating film whose insulating properties are less likely to deteriorate in a high-humidity environment, a method for forming an insulating film, an insulating film, and a printed wiring board.

### Description of Embodiments

### 1. Active ray curable inkjet ink composition

The active ray curable inkjet ink composition according to the present embodiment includes an active ray polymerizable compound, and is used for forming an insulating film on an electronic member. In the present specification, "forming an insulating film on an electronic member" refers to forming an insulating film that covers an exposed metal surface included in the electronic member.

The active ray polymerizable compound contains the following: an active ray polymerizable compound having a carboxyl group; and an amine-modified oligomer having no carboxyl group.

The present inventors have found that the active ray curable inkjet ink composition can form an insulating film having sufficiently enhanced adhesion to a metal surface of an electronic member and can form an insulating film whose insulating properties are less likely to deteriorate in a high-humidity environment.

A carboxyl group easily interacts with a metal. Therefore, of the carboxyl groups contained in the polymer of the active ray polymerizable compound, a carboxyl group located in the vicinity of the metal surface covered with the insulating film can interact with the metal surface to sufficiently enhance the adhesion.

On the other hand, according to the present inventors, since carboxyl groups are hydrophilic, the insulating film easily absorbs water due to a carboxyl group that does not interact with the metal surface (free carboxyl group). Therefore, when voltage is applied to metal on which an insulating film is formed under a high-humidity environment, insulation failure is more likely to occur due to occurrence of ion migration.

Meanwhile, in the present embodiment, using the above-described amine-modified oligomer in addition to the active ray polymerizable compound having a carboxyl group allows the amine-modified site of the amine-modified oligomer to react with a free carboxyl group, thereby reducing the amount of the free carboxyl groups. Thus, the water absorption of the insulating film due to the presence of the carboxyl groups not interacting with the metal surface can be suppressed. Therefore, even under a high-humidity environment, the occurrence of ion migration can be suppressed, and insulation failure of the insulating film can be suppressed.

In the present specification, the "insulating film" refers to a cured film which is formed by irradiating the active ray curable inkjet ink composition with active rays and has an electric resistance value of 1.0 × 10⁸ Ω or more. The electric resistance value can be measured by a method in accordance with the electrical property test of JISC5012: 1993.

In the present embodiment, the insulating film can be formed by reducing the amount of impurities (conductive substance and ionic impurities) in the ink composition. Specifically, the amount of impurities in the ink composition can be reduced by a method in which neutralization washing of the active ray polymerizable compound with water and filtration treatment of the active ray polymerizable compound are performed, or when the ink composition contains a pigment, by performing purification of the pigment (e.g., washing treatment with water) and adjustment of the content of the pigment.

Hereinafter, the active ray curable inkjet ink composition of the present invention based on the above-described finding will be described in more detail.

### 1-1. Active ray polymerizable compound

The active ray polymerizable compound contained in the ink according to the present embodiment is a compound that is polymerized and crosslinked by irradiation with active rays. In the present embodiment, the active ray polymerizable compound may be a compound that is further polymerized and crosslinked by being heated after irradiation with active rays.

Examples of the active rays include electron beams, ultraviolet rays, α-rays, γ-rays, and X-rays. Among these, ultraviolet rays and electron beam are preferable, and ultraviolet rays are more preferable.

The active ray polymerizable compound may be a cationically polymerizable compound or a radically polymerizable compound, but is preferably a radically polymerizable compound. The radically polymerizable compound is a compound having a radically polymerizable ethylenically unsaturated bond.

As described above, the active ray polymerizable compound includes an active ray polymerizable compound that has a carboxyl group and an amine-modified oligomer that has no carboxyl group.

### 1-1-1. Active ray polymerizable compound having carboxyl group

The active ray polymerizable compound having a carboxyl group is preferably a radically polymerizable compound. The ink may contain only one type of radically polymerizable compound or two or more types of radically polymerizable compounds in combination.

Examples of the active ray polymerizable compound having a carboxyl group, as the radically polymerizable compound, include (meth)acrylic acid, carboxyethyl (meth)acrylate, 2-acryloyloxyethyl phthalate, and 2-acryloyloxyethyl hexahydrophthalate. Among these, the radically polymerizable compound is preferably (meth)acrylic acid or carboxyethyl (meth)acrylate. In the present specification, "(meth)acrylate" means acrylate or methacrylate, and "(meth)acrylic" means acrylic or methacrylic.

The active ray polymerizable compound having a carboxyl group may be monofunctional or polyfunctional. From the viewpoint of preventing deterioration in adhesion due to curing shrinkage of the insulating film, the active ray polymerizable compound having a carboxyl group is preferably a compound having five or fewer functionalities.

Furthermore, the active ray polymerizable compound having a carboxyl group is preferably a compound represented by the general formula (1).

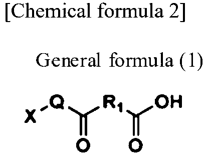

In the general formula (1), R₁ represents an unsubstituted alkylene group having 1 or more and 6 or less carbon atoms, Q represents an oxygen atom or NR₂, R₂ represents a hydrogen atom, a substituted or unsubstituted alkyl group, or a substituted or unsubstituted aryl group, X represents a structure derived from an alcohol or an amine and, X has, at a terminal thereof, at least one polymerizable group selected from the group consisting of a (meth)acryloyl group, an aryl group, and a vinyl group.

In the molecule thereof, the compound represented by the general formula (1) has two carbonyl groups (C (= O)) with an unsubstituted alkylene group therebetween. Thus, two oxygen atoms included in the two carbonyl groups and the metal atom form a coordinate bond, so that the adhesion of the insulating film can be sufficiently increased.

From the viewpoint of making the coordinate bond between the two oxygen atoms and the metal atom more stable to more sufficiently enhance the adhesion of the insulating film, R₁ is preferably an unsubstituted alkylene group having 1 or more and 4 or less carbon atoms, and from the viewpoint of further enhancing the adhesion, R₁ is preferably an unsubstituted alkylene group having 1 or 2 carbon atoms. Accordingly, when the coordinate bond is formed, a ring structure is formed by the metal atom, the two oxygen atoms, and R₁ (alkylene group), and the coordinate bond is further stabilized. From the same viewpoint, Q is preferably an oxygen atom.

Furthermore, the polymerizable group that X has at its terminal is preferably a (meth)acryloyl group. Since (meth)acryloyl groups have high reactivity and therefore easily polymerized and incorporated into the coating film. Therefore, the compound having a (meth)acryloyl group as a polymerizable group can sufficiently exert the effect of improving adhesion due to the carboxyl group.

Examples of the compound represented by the general formula (1) include the following compounds.

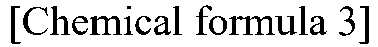

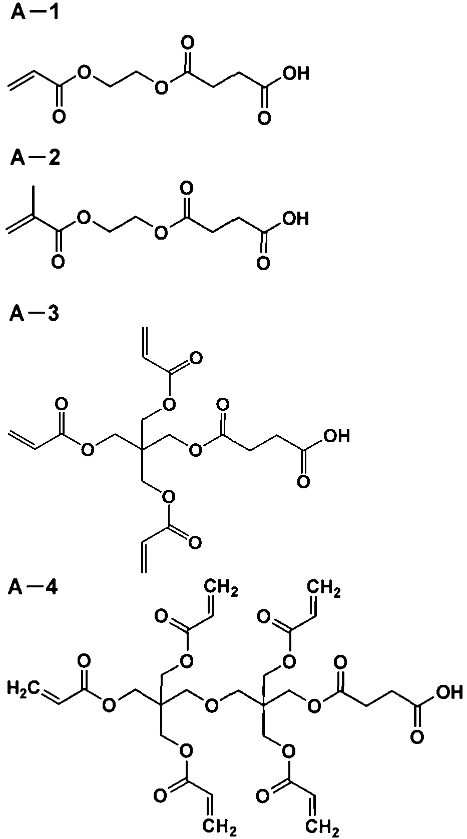

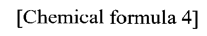

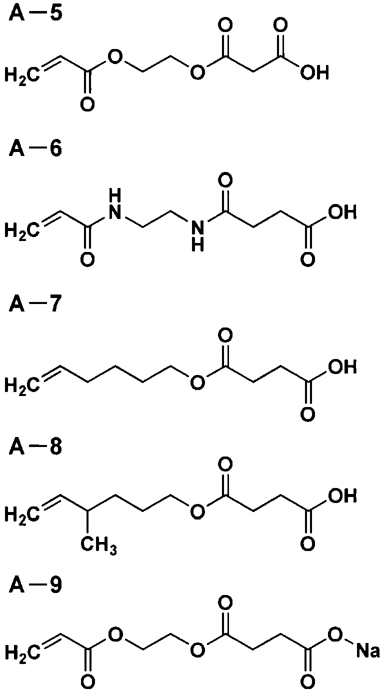

The active ray polymerizable compound having a carboxyl group may be a monomer or an oligomer, but is preferably a monomer. Note that in the present specification, the term "monomer" refers to an active ray polymerizable compound that is a monomer having a molecular weight of less than 700. The molecular weight can be measured by gel permeation chromatography.

The content of the active ray polymerizable compound having a carboxyl group is preferably 1% by mass or more and 50% by mass or less, more preferably 3% by mass or more and 20% by mass or less, with respect to the total mass of the active ray curable inkjet ink composition. When the content is 1% by mass or more, the adhesion of the insulating film to a metal surface can be more sufficiently increased. When the content is 50% by mass or less, the amount of the amine-modified oligomer can be increased to further suppress the water absorption of the insulating film, thereby further suppressing insulation failure under a high-humidity environment.

### 1-1-2. Amine-modified oligomer

In the present embodiment, the amine-modified oligomer does not have a carboxyl group. In the present specification, the term "oligomer" refers to an active ray polymerizable compound that is a dimer, trimer, or higher and has a molecular weight of 700 or more and 10,000 or less. The molecular weight of the amine-modified oligomer is preferably 800 or more and 5000 or less. The molecular weight can be measured by gel permeation chromatography.

The amine-modified oligomer is preferably a radically polymerizable compound. Examples of the amine-modified oligomer as the radically polymerizable compound include an amine-modified (meth)acrylate.

The content of the amine-modified oligomer is preferably 10% by mass or more and 100% by mass or less, more preferably 20% by mass or more and 75% by mass or less, with respect to the total mass of the active ray polymerizable compounds having a carboxyl group. When the content is 25% by mass or more, water absorption of the insulating film can be further suppressed, and insulation failure of the insulating film under a high-humidity environment can be further suppressed. When the content is 100% by mass or less, a decrease in the content of the active ray polymerizable compound having a carboxyl group is suppressed, and the adhesion is more sufficiently enhanced.

### 1-1-3. Others

The active ray polymerizable compound may include an active ray polymerizable compound other than the active ray polymerizable compound having a carboxyl group and the amine-modified oligomer.

Examples of the other active ray polymerizable compounds include radically polymerizable compound and cationically polymerizable compound. Among these, the other active ray polymerizable compound is preferably a radically polymerizable compound.

Examples of the radically polymerizable compound include unsaturated carboxylic acid esters and (meth)acrylates. Among these, (meth)acrylates are preferred. The (meth)acrylate may be monofunctional or polyfunctional.

Examples of monofunctional (meth)acrylates include isoamyl acrylate, stearyl acrylate, lauryl acrylate, octyl acrylate, decyl acrylate, isomyristyl acrylate, isostearyl acrylate, 2-ethylhexyl-diglycol acrylate, butoxyethyl acrylate, ethoxydiethylene glycol acrylate, methoxydiethylene glycol acrylate, methoxypolyethylene glycol acrylate, methoxypropylene glycol acrylate, phenoxyethyl acrylate, o-phenylphenol acrylate, nonylphenol acrylate, 2-hydroxy-3-phenoxypropyl acrylate, cumylphenoxyl ethyl acrylate, tetrahydrofurfuryl acrylate, isobornyl acrylate, 2-hydroxyethyl acrylate, 2-hydroxypropyl acrylate, 2-hydroxybutyl acrylate, and t-butylcyclohexyl acrylate.

Examples of bifunctional (meth)acrylates include triethylene glycol di(meth)acrylate, tetraethylene glycol di(meth)acrylate, polyethylene glycol di(meth)acrylate, dipropylene glycol di(meth)acrylate, tripropylene glycol di(meth)acrylate, polypropylene glycol di(meth)acrylate, 1,4-butanediol di(meth)acrylate, 1,6-hexanediol di(meth)acrylate, 1,9-nonanediol di(meth)acrylate, neopentyl glycol di(meth)acrylate, bisphenol-A PO adduct di(meth)acrylate, hydroxypivalate neopentyl glycol di(meth)acrylate, polytetramethylene glycol di(meth)acrylate, and tricyclodecanedimethanol di(meth)acrylate.

Examples of tri- or higher functional (meth)acrylates include trimethylolpropane tri(meth)acrylate, pentaerythritol tri(meth)acrylate, pentaerythritol tetra(meth)acrylate, dipentaerythritol hexa(meth)acrylate, trimethylolpropane tetra(meth)acrylate, glycerol propoxy tri(meth)acrylate, and pentaerythritol ethoxy tetra(meth)acrylate.

The (meth)acrylate may be, for example, modified with an alkylene oxide such as ethylene oxide (EO) or propylene oxide (PO), or caprolactone (namely, modified (meth)acrylate). Examples of the modified (meth)acrylate include caprolactone-modified acrylates such as o-phenylphenol EO-modified (meth)acrylate, EO-modified trimethylolpropane tri(meth)acrylate, EO-modified pentaerythritol tetra(meth)acrylate, EO-modified hexanediol di(meth)acrylate, PO-modified trimethylolpropane tri(meth)acrylate, PO-modified pentaerythritol tetra(meth)acrylate, nonylphenol PO-modified (meth)acrylate, propoxylated neopentyl glycol di(meth)acrylate, propoxylated trimethylolpropane tri(meth)acrylate, and caprolactone-modified trimethylolpropane tri(meth)acrylate; and caprolactam-modified dipentaerythritol hexa(meth)acrylate.

Examples of the cationically polymerizable compound include epoxy compounds, vinyl ether compounds, and oxetane compounds.

Examples of the epoxy compound include 3,4-epoxycyclohexylmethyl-3',4'-epoxycyclohexanecarboxylate, bis(3,4-epoxycyclohexylmethyl) adipate, vinylcyclohexene monoepoxide, ε-caprolactone-modified 3,4-epoxycyclohexylmethyl 3',4'-epoxycyclohexanecarboxylate, 1-methyl-4-(2-methyloxiranyl)-7-oxabicyclo [4,1,0]heptane, 2-(3,4-epoxycyclohexyl-5,5-spiro-3,4-epoxy) cyclohexanone-meta-dioxane, bis(2,3-epoxycyclopentyl) ether, diglycidyl ether of 1,4-butanediol, diglycidyl ether of 1,6-hexanediol, triglycidyl ether of glycerin, triglycidyl ether of trimethylolpropane, diglycidyl ether of polyethylene glycol, diglycidyl ether of propylene glycol, and diglycidyl ethers of ethylene glycol, propylene glycol, and glycerin.

Examples of the vinyl ether compound include monovinyl ether compounds such as ethyl vinyl ether, n-butyl vinyl ether, isobutyl vinyl ether, octadecyl vinyl ether, cyclohexyl vinyl ether, hydroxybutyl vinyl ether, 2-ethylhexyl vinyl ether, cyclohexanedimethanol monovinyl ether, n-propyl vinyl ether, isopropyl vinyl ether, isopropenyl ether-o-propylene carbonate, dodecyl vinyl ether, diethylene glycol monovinyl ether, and octadecyl vinyl ether; and di-or trivinyl ether compounds such as ethylene glycol divinyl ether, diethylene glycol divinyl ether, triethylene glycol divinyl ether, propylene glycol divinyl ether, dipropylene glycol divinyl ether, butanediol divinyl ether, hexanediol divinyl ether, cyclohexanedimethanol divinyl ether, and trimethylolpropane trivinyl ether.

Examples of the oxetane compound include 3-hydroxymethyl-3-methyloxetane, 3-hydroxymethyl-3-ethyloxetane, 3-hydroxymethyl-3-propyloxetane, 3-hydroxymethyl-3-n-butyloxetane, 3-hydroxymethyl-3-phenyloxetane, 3-hydroxymethyl-3-benzyloxetane, 3-hydroxyethyl-3-methyloxetane, 3-hydroxyethyl-3-ethyloxetane, 3-hydroxyethyl-3-propyloxetane, 3-hydroxyethyl-3-phenyloxetane, 3-hydroxypropyl-3-methyloxetane, 3-hydroxypropyl-3-ethyloxetane, 3-hydroxypropyl-3-propyloxetane, 3-hydroxypropyl-3-phenyloxetane, 3-hydroxybutyl-3-methyloxetane, 1,4 bis{[(3-ethyl-3-oxetanyl) methoxy] methyl} benzene, 3-ethyl-3-(2-ethylhexyloxymethyl) oxetane, and di[1-ethyl (3-oxetanyl)] methyl ether.

The content of the other active ray polymerizable compound is preferably 50% by mass or more and 90% by mass or less with respect to the total mass of the active ray curable inkjet ink composition.

### 1-2. Polymerization initiator

In the present embodiment, the active ray curable inkjet ink composition may include a polymerization initiator.

The polymerization initiator is a compound that initiates polymerization and crosslinking of the active ray polymerizable compound by irradiation with active rays. Note that the ink does not have to contain a polymerization initiator in a case where polymerization and crosslinking of the active ray polymerizable compound can be initiated without a polymerization initiator, such as a case where the ink is cured by irradiation with electron beams.

The polymerization initiator can be a radical polymerization initiator when the ink contains a radically polymerizable compound, and can be a cationic polymerization initiator when the ink contains a cationically polymerizable compound. Examples of the radical polymerization initiator include an intramolecular bond cleavage type radical polymerization initiator and an intramolecular hydrogen abstraction type radical polymerization initiator.

Examples of the intramolecular bond cleavage type radical polymerization initiator include acetophenone-based initiators such as diethoxyacetophenone, 2-hydroxy-2-methyl-1-phenylpropan-1-one, benzyl dimethyl ketal, 1-(4-isopropylphenyl)-2-hydroxy-2-methylpropan-1-one, 4-(2-hydroxyethoxy)phenyl-(2-hydroxy-2-propyl)ketone, 1-hydroxycyclohexyl-phenylketone, 2-methyl-2-morpholino (4-methylthiophenyl) propan-1-one, and 2-benzyl-2-dimethylamino-1-(4-morpholinophenyl)-butanone; benzoin-based initiators such as benzoin, benzoin methyl ether, and benzoin isopropyl ether; acylphosphine oxide-based initiators such as bis-2,4,6-trimethylbenzoin diphenylphosphine oxide; benzyl; and methylphenyl glyoxy esters.

Examples of the intramolecular hydrogen-abstraction type radical polymerization initiator include benzophenone-based initiators such as benzophenon, methyl o-benzoylbenzoate, 4-phenylbenzophenone, 4,4'-dichlorobenzophenone, hydroxybenzophenone, 4-benzoyl-4'-methyl-diphenyl sulfide, acrylated benzophenon, 3,3',4,4'-tetra(t-butylperoxycarbonyl) benzophenon, and 3,3'-dimethyl-4-methoxybenzophenone; thioxanthone-based initiators such as 2-isopropylthioxanthone, 2,4-dimethylthioxanthone, 2,4-diethylthioxanthone, and 2,4-dichlorothioxanthone; aminobenzophenone-based initiators such as Michler's ketone and 4,4'-diethylaminobenzophenone; 10-butyl-2-chloroacridone; 2-ethylanthraquinone; 9,10-phenanthrenequinone; and camphorquinone.

Examples of the cationic polymerization initiator include a photoacid generator. Examples of the photoacid generator include B(C₆F₅)₄-, PF₆-, AsF₆-, SbF₆-, CF₃SO₃- salts of aromatic onium compounds including diazonium, ammonium, iodonium, sulfonium, phosphonium and the like, sulfonated products that generate sulfonic acid, halides that generate hydrogen halide by light, and iron-allene complexes.

The content of the polymerization initiator is preferably 1% by mass or more and 10% by mass or less and more preferably 2% by mass or more and 8% by mass or less with respect to the total mass of the active ray curable inkjet ink composition.

### 1-3. Gelling agent

In the present embodiment, the active ray curable inkjet ink composition may contain a gelling agent.

The gelling agent causes the ink to be solated when the ink is heated and to be gelled at around room temperature. Thus, the ink that has been heated and turned into a sol can be ejected from an inkjet head, and the ink that has landed on a recording medium and been cooled and turned into a gel can be temporarily solidified to enhance the pinning properties of the ink. Thus, wet-spreading of the ink is suppressed, and adjacent dots are less likely to coalesce with each other, making it possible to form a higher-definition pattern.

In addition, since the active ray curable ink composition includes a gelling agent, the hydrophobicity of the insulating film to be formed is increased, and thus the water absorption of the insulating film can be further suppressed. Thus, the occurrence of ion migration under a high-humidity environment can be further suppressed, and a decrease in insulating properties can be sufficiently suppressed.

The gelling agent is preferably a compound that dissolves in an active ray polymerizable compound contained in the ink at a temperature higher than the gelation temperature of the ink and crystallizes in the ink at a temperature equal to or lower than the gelation temperature of the ink. Here, the "gelation temperature" means a temperature at which the viscosity of the ink suddenly changes due to the phase transition of the ink from sol to gel when the ink having been solated or liquefied by heating is cooled. Specifically, the solated or liquefied ink is cooled while measuring the viscosity with a viscoelasticity measurement apparatus (for example, MCR300, manufactured by Physica), and the temperature at which the viscosity rapidly increases is taken as the gelation temperature of the ink.

It is preferable that the gelling agent is crystallized in the ink at a temperature equal to or lower than the gelation temperature of the ink to form a structure in which the radically polymerizable compound is contained in a three dimensional space formed by the gelling agent crystallized in a plate shape (such a structure is hereinafter referred to as "card house structure"). When the card house structure is formed, a liquid active ray polymerizable compound is held in the space, and thus dots formed by adhesion of an ink to a recording medium are less likely to wet and spread, further enhancing the pinning properties of the ink. Thus, dots formed by adhesion of the ink to the recording medium are less likely to coalesce with each other.

Examples of the gelling agent that can more easily form a card house structure by crystallization include aliphatic ketones, aliphatic esters, petroleum-based waxes, plant-based waxes, animal-based waxes, mineral-based waxes, hydrogenated castor oil, modified waxes, higher fatty acids, higher alcohols, hydroxystearic acid, fatty acid amides including N-substituted fatty acid amides and special fatty acid amides, higher amines, sucrose fatty acid esters, synthetic waxes, dibenzylidene sorbitol, dimer acids, and dimer diols.

Examples of the aliphatic ketone include dilignoceryl ketone, dibehenyl ketone, distearyl ketone, dieicosyl ketone, dipalmityl ketone, dilauryl ketone, dimyristyl ketone, myristyl palmityl ketone, and palmityl stearyl ketone.

Examples of the aliphatic ester include fatty acid esters of monoalcohols such as behenyl behenate, icosyl icosanoate, stearyl stearate, palmityl stearate, myristyl myristate, cetyl myristate, and oleyl palmitate; and fatty acid esters of polyhydric alcohols such as glycerin fatty acid ester, sorbitan fatty acid ester, propylene glycol fatty acid ester, ethylene glycol fatty acid ester, and polyoxyethylene fatty acid ester.

Examples of commercially available products of the aliphatic ester include EMALEX series (manufactured by Nippon Emulsion Co., Ltd. ("EMALEX" is a registered trade mark of the company)), RIKEMAL series and POEM series (manufactured by Riken Vitamin Co., Ltd. ("RIKEMAL" and "POEM" are both registered trademarks of the company)).

Examples of the higher fatty acid include behenic acid, arachidic acid, stearic acid, palmitic acid, myristic acid, lauric acid, oleic acid, and erucic acid.

Examples of the higher alcohol include stearyl alcohol and behenyl alcohol.

Among these, from the viewpoint of further improving the pinning properties, the gelling agent is preferably an aliphatic ketone, an aliphatic ester, a higher fatty acid, or a higher alcohol, more preferably an aliphatic ketone represented by the following general formula (G1) or an aliphatic ester represented by the following general formula (G2). The active ray curable inkjet ink composition may contain only one type of gelling agent or two or more types of gelling agents in combination.

General formula (G1): Rₐ-CO-R_{b}

general formula (G2): R_{c}-COO-R_{d}

In the general formula (G1), Rₐ and R_{b} independently represent a linear hydrocarbon group which has 12 or more and 26 or less carbon atoms and may have a branched chain, and in the general formula (G2), R_{c} and R_{d} independently represent a linear hydrocarbon group which has 12 or more and 26 or less carbon atoms and may have a branched chain.

In the general formulae (G1) and (G2), when the number of carbon atoms of Rₐ to R_{d} is equal to or greater than 12, the crystallinity of the gelling agents represented by the general formula (G1) and general formula (G2) is further increased, and a more sufficient space is generated in the card house structure. Therefore, the active ray polymerizable compound (A) is more likely to be sufficiently included in the space, and the pinning properties of the ink is improved.

In addition, when the number of carbon atoms of Rₐ to R_{d} is 26 or less, it is possible to suppress an excessive increase in the melting points of the gelling agents represented by the general formula (G1) and general formula (G2). This prevents the solation temperature of the ink containing the gelling agent from becoming too high, and allows the ink to be ejected at a low heating temperature.

Examples of aliphatic ketones represented by the general formula (G1) include dilignoceryl ketone (number of carbon atoms: 23-24), dibehenyl ketone (number of carbon atoms: 21-22), distearyl ketone (number of carbon atoms: 17-18), dieicosyl ketone (number of carbon atoms: 19-20), dipalmityl ketone (number of carbon atoms: 15-16), dimyristyl ketone (number of carbon atoms: 13-14), dilauryl ketone (number of carbon atoms: 11-12), lauryl myristyl ketone (number of carbon atoms: 11-14), lauryl palmityl ketone (11-16), myristyl palmityl ketone (13-16), myristyl stearyl ketone (13-18), myristyl behenyl ketone (13-22), palmityl stearyl ketone (15-18), palmityl behenyl ketone (15-22), and stearyl behenyl ketone (17-22). The number of carbon atoms in the above parentheses represents the number of carbon atoms of each of two hydrocarbon groups separated by a carbonyl group.

Examples of commercially available products of the compound represented by the general formula (G1) include 18-Pentatriacontanon and Hentriacontan-16-on (all manufactured by Alfa Aeser), and KAO WAX T1 (manufactured by Kao Corporation).

Examples of the aliphatic ester represented by the general formula (G2) include behenyl behenate (number of carbon atoms: 21-22), icosyl icosanoate (number of carbon atoms: 19-20), stearyl stearate (number of carbon atoms: 17-18), palmityl stearate (number of carbon atoms: 17-16), lauryl stearate (number of carbon atoms: 17-12), cetyl palmitate (number of carbon atoms: 15-16), stearyl palmitate (number of carbon atoms: 15-18), myristyl myristate (number of carbon atoms: 13-14), cetyl myristate (number of carbon atoms: 13-16), octyldodecyl myristate (number of carbon atoms: 13-20), stearyl oleate (number of carbon atoms: 17-18), stearyl erucate (number of carbon atoms: 21-18), stearyl linoleate (number of carbon atoms: 17-18), behenyl oleate (number of carbon atoms: 18-22), and arachidyl linoleate (number of carbon atoms: 17-20). The number of carbon atoms in the above parentheses represents the number of carbon atoms of each of the two hydrocarbon groups separated by the ester group.

Examples of commercially available products of the aliphatic ester represented by the general formula (G2) include UNISTER M-2222SL, SPERMACETI, Nissan Electol WEP-2 and Nissan Electol WEP-3 (all manufactured by NOF Corporation, "UNISTER" and "Nissan Electol" are registered trademarks of the same company), EXCEPARL SS and EXCEPARL MY-M (all manufactured by Kao Corporation, "EXCEPARL" is a registered trademark of the same company), EMALEX CC-18 and EMALEX CC-10 (manufactured by Nihon Emulsion Co., Ltd., "EMALEX" is a registered trademark of the same company), and AMREPS PC (manufactured by Higher Alcohol Industries, Ltd., "AMREPS" is a registered trademark of the same company). These commercially available products are often mixtures of two or more types, and therefore, may be separated and purified as necessary to be contained in an ink.

The content of the gelling agent is preferably 1% by mass or more and 10% by mass or less, more preferably 1% by mass or more and 5% by mass or less with respect to the total mass of the ink. When the content is 1% by mass or more, the water absorption of the insulating film can be further suppressed, and the decrease in the insulating properties under a high-humidity environment can be further suppressed. When the content is 10% by mass or less, the solubility of the gelling agent in the active ray polymerizable compound can be further increased.

### 1-4. Others

The active ray curable inkjet ink composition according to the present embodiment may further contain other components, such as a coloring agent, a surfactant, a polymerization inhibitor, and a humectant, to the extent that the effects of the present invention are exhibited.

### (Coloring agent)

The coloring agent is a dye or a pigment, but a pigment is preferable because it has good dispersibility in constituent components of the ink and is excellent in weather resistance. The pigment can be selected from, for example, yellow pigments, red pigments, blue pigments, black pigments, and white pigments depending on the color of the image to be formed.

Examples of the yellow pigments include Pigment Yellow (PY) 1, 3, 12, 13, 14, 17, 34, 35, 37, 55, 74, 81, 83, 93, 94, 95, 97, 108, 109, 110, 137, 138, 139, 153, 154, 155, 157, 166, 167, 168, 180, 185, 193, and the like. Among these, PY185 and PY150 are preferable from the viewpoint of further reducing the impurity amount in the ink composition to further increase the electric resistance value of the insulating film.

Examples of red pigments include Pigment Red (PR) 3, 5, 19, 22, 31, 38, 43, 48:1, 48:2, 48:3, 48:4, 48:5, 49:1, 53:1, 57:1, 57:2, 58:4, 63:1, 81, 81:1, 81:2, 81:3, 81:4, 88, 104, 108, 112, 122, 123, 144, 146, 149, 166, 168, 169, 170, 177, 178, 179, 184, 185, 208, 216, 226, 257, Pigment Violet (PV) 3, 19, 23, 29, 30, 37, 50, 88, and Pigment Orange (PO) 13, 16, 20, and 36. Among these, from the viewpoint of further reducing the impurity amount in the ink composition to further increase the electric resistance value of the insulating film, PR122 and PV19 are preferable.

Examples of blue pigments include Pigment Blue (PB) 1, 15, 15:1, 15:2, 15:3, 15:4, 15:6, 16, 17:1, 22, 27, 28, 29, 36, 60, and the like. Among these, PB15:3 and PB15:4 are preferable from the viewpoint of further reducing the impurity amount in the ink composition to further increase the electric resistance value of the insulating film.

Examples of green pigments include C. I. Pigment Green (hereinafter, also simply referred to as "PG") 7, PG26, PG36, and PG50.

Examples of the black pigment include C. I. Pigment Black (hereinafter, also simply referred to as "PBk") 7, PBk26, and PBk28.

The white pigment may be any pigment that imparts a white color to a cured film of a white ink. Examples of the white pigment include inorganic pigments such as titanium oxide, zinc oxide, calcium carbonate, barium sulfate, and aluminum hydroxide. Among these, titanium oxide is preferable.

The crystal form of the titanium oxide may be any of a rutile type, an anatase type, and a brookite type, but from the viewpoint of making it easier to make the particle diameter of the white pigment smaller, the anatase type having a small specific gravity is preferable, and from the viewpoint of further enhancing the opacity of an image to be formed, the rutile type having a large refractive index in the visible light region is preferable.

The content of the coloring agent is preferably 0.1% by mass or more and 10% by mass or less and more preferably 1% by mass or more and 5% by mass or less with respect to the total mass of the ink composition. When the coloring agent is a pigment, from the viewpoint of reducing the amount of impurities in the ink composition, the content of the pigment is preferably 20% by mass or less and more preferably 10% by mass or less with respect to the total mass of the ink composition.

### (Pigment-dispersing agent)

When the active ray curable inkjet ink composition contains a pigment, the ink composition may contain a pigment-dispersing agent.

Examples of the pigment-dispersing agent include hydroxyl group-containing carboxylic acid esters, salts of long-chain polyaminoamides and high-molecular weight acid esters, salts of high-molecular weight polycarboxylic acids, salts of long-chain polyaminoamides and polar acid esters, high-molecular weight unsaturated acid esters, high-molecular weight copolymers, modified polyurethanes, modified polyacrylates, polyether ester-type anionic surfactants, naphthalenesulfonic acid-formalin condensate salts, aromatic sulfonic acid-formalin condensate salts, polyoxyethylene alkyl phosphate esters, polyoxyethylene nonylphenyl ether, and stearylamine acetate. Examples of commercially available products of the dispersing agent include Solsperse (R) series manufactured by Avecia Inc, and PB series manufactured by Ajinomoto Fine-Techno Co., Inc.

The content of the pigment-dispersing agent is preferably 1% by mass or more and 50% by mass or less with respect to the mass of the pigment.

### (Surfactant)

Examples of the surfactant include anionic surfactants such as dialkyl sulfosuccinates, alkyl naphthalene sulfonates, and fatty acid salts; nonionic surfactants such as polyoxyethylene alkyl ethers, polyoxyethylene alkyl allyl ethers, acetylene glycols, and polyoxyethylene-polyoxypropylene block copolymers; cationic surfactants such as alkylamine salts, and quaternary ammonium salts; and silicone-based andfluorine-based surfactants.

Examples of commercially available silicone-based surfactants include Tego rad 2250 (manufactured by Evonik), KF 351A, KF 352A, KF 642, and X-22 4272; (manufactured by Shin-Etsu Chemical Co., Ltd), BYK307, BYK345, BYK347, and BYK348 (manufactured by Byk-Chemie GmbH ("BYK" is a registered trade mark of the company)), TSF4452 (manufactured by Momentive Performance Materials Inc), and the like.

Examples of commercially available products of fluorosurfactants include Megafac F (manufactured by DIC Corporation ("Megafac" is a registered trade mark of the company)), Surflon (manufactured by AGC Pure Chemical Co., Ltd. ("Surflon" is a registered trade mark of the company)), Fluorad FC (manufactured by 3M Corporation ("Fluorad" is a registered trade mark of the company)), Monflor (manufactured by Imperial Chemical Industries, Inc), Zonyls (manufactured by E. I. du Pont de Nemours and Company), Licowet VPF (manufactured by Lubewerke Hoechst), and FTERGENT (manufactured by Neos Co., Ltd. ("FTERGENT" is a registered trade mark of the company)).

The content of the surfactant with respect to the total mass of the ink is not particularly limited as long as the effect of the present invention is exhibited, but for example, the content can be 0.001 % by mass or more and less than 1.0% by mass.

### (Polymerization inhibitor)

Examples of the polymerization inhibitor include N-oxyl-based polymerization inhibitors, phenol-based polymerization inhibitors, quinone-based polymerization inhibitors, amine-based polymerization inhibitors, and copper dithiocarbamate-based polymerization inhibitors. The ink may contain only one type of polymerization inhibitor or two or more types of polymerization inhibitors in combination.

Examples of the N-oxyl-based polymerization inhibitor include 4-hydroxy-2,2,6,6-tetramethylpiperidine-N-oxyl (TEMPO), 4-hydroxy-2,2,6,6-tetramethyl-piperidine-N-oxyl, 4-oxo-2,2,6,6-tetramethyl-piperidine-N-oxyl, 4-methoxy-2,2,6,6-tetramethyl-piperidine-N-oxyl, 4-acetoxy-2,2,6,6-tetramethyl-piperidine-N-oxyl, and the like. Examples of commercially available products of the N-oxyl-based polymerization inhibitor include Irgastab UV10 (manufactured by BASF ("Irgastab" is a registered trade mark of the company)).

Examples of the phenol-based polymerization inhibitor include 2,6-di-tert-butylphenol, 2,4-di-tert-butylphenol, 2-tert-butyl 4,6-dimethylphenol, 2,6-di-tert-butyl-4-methylphenol, 2,4,6-tri-tert-butylphenol, 2,6-di-t-butyl-p-cresol (butylated hydroxytoluene: BHT), 4-methoxyphenol, and 2-methoxy-4-methylphenol.

Examples of the quinone-based polymerization inhibitor include hydrochinone, methoxyhydroquinone, benzoquinone, 1,4-naphthoquinone, p-tert-butylcatechol and the like.

Examples of the amine-based polymerization inhibitor include alkylated diphenylamine, N,N'-diphenyl-p-phenylenediamine, and phenothiazine.

Examples of the copper dithiocarbamate-based polymerization inhibitor include copper dimethyldithiocarbamate, copper diethyldithiocarbamate, copper dibutyldithiocarbamate, and the like.

The content of the polymerization inhibitor is not particularly limited as long as the effect of the present invention is exhibited, but for example, is preferably 0.01% by mass or more and 1% by mass or less, more preferably 0.05% by mass or more and 0.5% by mass or less, with respect to the total mass of the active ray curable inkjet ink composition.

### 1-5. Physical Property

When the active ray curable inkjet ink composition does not contain a gelling agent, the viscosity of the ink composition at 40°C is preferably 7 mPa·s or more and 15 mPa·s or less, more preferably 8 mPa·s or more and 13 mPa·s or less. When the viscosity is within the above range, the ejection stability of the ink can be further improved.

When the ink composition contains a gelling agent, the viscosity of the ink composition at 80°C is preferably 3 mPa·s or more and 20 mPa·s or less, and more preferably in the range of 7 mPa·s or more and 9 mPa·s or less, from the viewpoint of further enhancing the ejection property from an inkjet head.

When the ink composition contains a gelling agent, the ink composition preferably undergoes a sol-gel phase transition at a temperature of 40°C or higher and lower than 100°C. The gelation temperature of the ink composition is preferably 40°C or more and 70°C or less. When the gelation temperature of the ink composition is 40°C or more, the ink is rapidly gelled after landing on a recording medium, and thus the pinning properties become higher. When the gelation temperature of the ink is 70°C or lower, the ink is less likely to be gelled at the time of ejection of the inkjet ink from an inkjet head in which the ink temperature is usually about 80°C, and thus the ink can be ejected more stably.

The viscosity at 40°C, the viscosity at 80°C, and the gelation temperature of the inkjet ink can be determined by measuring the change in the dynamic viscoelasticity of the ink with temperature using a rheometer (for example, a stress control type rheometer Physica MCR Series, manufactured by Anton Paar). Specifically, a temperature change curve of viscosity is obtained when the ink is heated to 100°C and cooled to 25°C under conditions of a shear rate of 11.7 (1/s) and a temperature lowering rate of 0.1°C/s. Then, the viscosity at 40°C and the viscosity at 80°C can be determined by reading the viscosities at 40°C and 80°C, respectively, in the viscosity-temperature change curve. The gelation temperature can be determined as a temperature at which the viscosity becomes 200 mPa·s in a temperature change curve of viscosity.

### 1-6. Method for preparing active ray curable inkjet ink composition

The ink according to the present embodiment can be prepared by mixing the components described above. At this time, in order to increase the solubility of each component, it is preferable to mix the components while heating.

Note that a pigment dispersion liquid containing the pigment and the pigment-dispersing agent may be prepared in advance, and the remaining components may be added thereto and mixed. At this time, the pigment can be dispersed with, for example, a ball mill, a sand mill, an attritor, a roll mill, an agitator, a Henschel mixer, a colloid mill, an ultrasound homogenizer, a pearl mill, a wet-type jet mill, or a paint shaker.

### 1-7. Use

The active ray curable inkjet ink composition according to the present embodiment can be used for forming an insulating film for an electronic member. Therefore, the ink composition can be used as, for example, an ink for a solder resist for forming an insulating film on a printed wiring board, an ink for forming an insulating film on a semiconductor/IC package, an RFID antenna, or the like, a semiconductor sealing agent ink, an underfill material ink, a die bonding material ink, a black matrix ink for an LED or an image display device, or a multilayer substrate prepreg ink.

### 2. Method for forming insulating film

The method for forming an insulating film (insulating film forming method) according to the present embodiment includes a step of applying the above-described active ray curable inkjet ink composition to a metal surface of an electronic member, and a step of curing the ink composition by irradiating the applied ink composition with active rays.

### 2-1. Step of applying ink

In this step, the above-described active ray curable inkjet ink composition (hereinafter, also simply referred to as "ink") is applied to a metal portion of an electronic member by an inkjet method.

The method of ejecting the ink from the inkjet head may be either an on-demand system or a continuous system. The inkjet head of the on-demand system may be any of electro-mechanical transduction systems such as a single cavity type, a double cavity type, a bender type, a piston type, a shear mode type, and a shared wall type, and electro-thermal transduction systems such as a thermal inkjet type and a bubble jet ("bubble jet" is a registered trademark of Canon Inc) type.

The temperature of an ink when the inkjet head is filled with the ink preferably set to 40°C or more and 100°C or less, and more preferably set to 40°C or more and 90°C or less, from the viewpoint of further enhancing the ejection characteristics from the inkjet head.

In particular, when the ink contains a gelling agent, the temperature of the ink when the inkjet head is filled with the ink is preferably set to a temperature from the gelation temperature of the ink + 10°C or more to the gelation temperature + 30°C or less for ejecting the droplets of the ink from the inkjet head in a heated and solated state. When the temperature of the active ray curable ink in the inkjet head is the gelation temperature + 10°C or more, a reduction in ejection characteristics due to gelation of the ink in the inkjet head or on the nozzle surface is less likely to occur. On the other hand, when the temperature of the ink in the inkjet head is the gelation temperature + 30°C or less, deterioration of the components due to a high temperature is less likely to occur.

The method of heating the ink is not particularly limited. For example, at least one of the ink supply system, such as the ink tank that constitutes the head carriage, the supply pipe, and the front chamber ink tank immediately before the head, the piping with filter, and the piezo head can be heated by a panel heater, ribbon heater, or heated water.

The droplet amount of the ejected ink is preferably 3.0 pL or more and 9.0 pL or less from the viewpoint of forming a finer pattern while increasing the pattern forming speed.

Examples of the electronic member include printed wiring boards, semiconductor/IC packages, mini-micro LEDs, and the like. Examples of the type of metal of the metal surface include copper, nickel, and aluminum.

### 2-2. Step of irradiating with active ray

In this step, the ink applied to the metal surface is cured by being irradiated with active rays.

The active rays can be selected from, for example, electron beams, ultraviolet rays, α rays, γ rays, and X-rays, and is preferably ultraviolet rays or electron beams. The ultraviolet ray is preferably light having peak wavelengths in a range of 360 nm to 410 nm inclusive. Furthermore, the ultraviolet rays are preferably emitted from an LED light source. Since an LED has less radiant heat as compared with a conventional light source (for example, a metal halide lamp or the like), by using the LED, ink is less likely to melt at the time of irradiation with active rays, and gloss unevenness or the like is less likely to be generated.

### 2-3. Heating step

The insulating film forming method according to the present embodiment may further include a step of heating the ink composition having been irradiated with active rays. Thus, the reaction between the carboxyl group of the active ray polymerizable compound having a carboxyl group, which has not interacted with a metal, and the amine-modified moiety of the amine-modified oligomer can be more accelerated. As a result, the insulating film is less likely to absorb water, and a decrease in the insulating properties of the insulating film under a high-humidity environment is less likely to occur.

Furthermore, when the active ray curable inkjet ink composition contains a gelling agent, the fluidity of the insulating film during heating is increased by performing this step. Thus, the frequency of contact between a carboxyl group (which has not interacted with the metal) and an amine-modified moiety of the amine-modified oligomer can be increased, thereby further promoting the reaction therebetween. As a result, the insulating film is less likely to absorb water, and a decrease in the insulating properties of the insulating film under a high-humidity environment is less likely to occur.

The heating temperature of the ink is not particularly limited as long as the amine-modified oligomer and the free carboxyl group can react with each other, but is preferably 140°C or more and 180°C or less. Furthermore, the heating time of the ink is preferably 30 minutes or more and 120 minutes or less, more preferably 30 minutes or more and 60 minutes or less.

### 3. Insulating film

The insulating film according to the present embodiment is formed by irradiating the above-described active ray curable inkjet ink composition with active rays. The insulating film can be formed by the above-described insulating film forming method.

The electric resistance value of the insulating film is 1.0 × 10⁸ Ω or more, preferably 1.0 × 10⁸ Ω or more and 1.0 × 10¹⁸ Ω or less, more preferably 1.0 × 10¹⁰ Ω or more and 1.0 × 10¹⁸ Ω or less, and still more preferably 1.0 × 10¹¹ Ω or more and 1.0 × 10¹⁸ Ω or less.

### 4. Printed wiring board

The printed wiring board according to the present embodiment has the above-described insulating film on a substrate.

As the substrate on which the insulating film is to be formed, a base substrate on which a conductive film such as a copper foil is formed can be used. The base substrate includes a rigid substrate and a flexible substrate.

Examples of the rigid substrate include paper phenol substrates, paper epoxy substrates, glass epoxy substrates, glass polyimide substrates, Teflon (registered trademark) substrates, PPO substrates, and composite base epoxy substrates.

Examples of the material of the flexible substrate include PET films and polyimide films.

### Examples

In the following, the present invention will be described with reference to the examples. The scope of the present invention should not be construed as being limited to the examples.

### 1. Preparation of material

### 1-1. Active ray polymerizable compound

### (active ray polymerizable compound having carboxyl group)

- Carboxyethyl acrylate
- Compound A-1 below
- Compound A-2 below
- Compound A-3 below

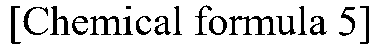

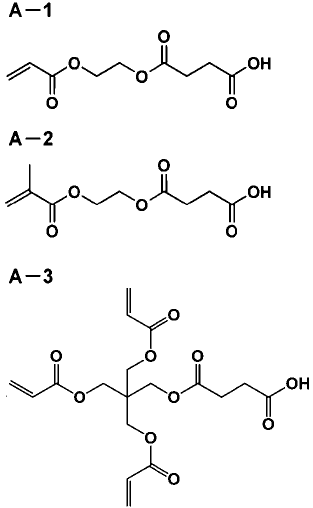

### (Active ray polymerizable compound having hydroxyl group)

### - 4-Hydroxybutyl acrylate

### (Amine-modified oligomer)

- Amine-modified oligomer 1 (no carboxyl group, molecular weight 1000, manufactured by Daicel Allnex Ltd., EBECRYL80)
- Amine-modified oligomer 2 (no carboxyl group, molecular weight 1600, manufactured by Sartomer Co., Ltd., CN371)

The molecular weight of the amine-modified oligomer was determined using a GPC apparatus equipped with "HLC-8120" (manufactured by Tosoh Corporation) and "TSKguard column + TSKgel Super HZM-M3 series" (manufactured by Tosoh Corporation) as a column, and a calibration curve obtained from a standard polystyrene sample.

### (Amine-modified monomer)

The following compound was used.

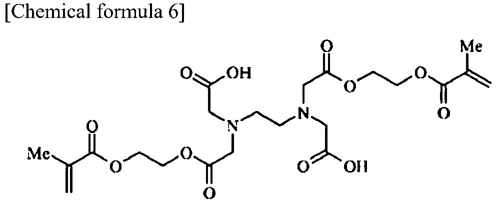

### (Others)

- Dipropylene glycol diacrylate (DPGDA)
- Trimethylolpropane PO-modified triacrylate (TMP (PO) 3TA)

### 1-2. Amine compound (no polymerizable group)

- N,N-dimethylamino-p-benzoic acid ethyl ester

### 1-3. Gelling agent

- Stearyl stearate (EXCEPARL SS, manufactured by Kao Corp.)

### 1-4. Polymerization initiator

- Initiator 1 (Omnirad 907, manufactured by IGM Resins B.V)
- Initiator 2 (Omnirad 819, manufactured by IGM Resins B.V)
- Initiator 3 (Speedcure ITX, manufactured by Sartomer)

### 1-5. Polymerization inhibitor

- Irgastab UV-10 (manufactured by BASF)

### 1-6. Preparation of pigment dispersion liquid

### (Preparation of yellow pigment dispersion liquid Y)

The following materials were placed in a stainless steel beaker, heated on a hot plate at 65°C for 1 hour while stirring and dissolving, and then cooled to room temperature. After that, 15.0 parts by mass of yellow pigment PY185 (Paliotol Yellow D1155, manufactured by BASF) was added to the stainless beaker. Thereafter, the mixed solution in the stainless beaker and 200 g of zirconia beads (diameter of 0.5 mm) were placed in a glass bottle, and the glass bottle was sealed. The mixed solution and the zirconia beads were subjected to a dispersion treatment with a paint shaker (5400, manufactured by Red Devil) until a desired particle diameter was attained, and then the zirconia beads were removed, to prepare a yellow pigment dispersion liquid Y.
- Pigment-dispersing agent 1 (EFKAPX4701, available from Basf SE): 11.2 parts by mass

- Pigment-dispersing agent 2 (Solsperse 22000,manufactured by Lubrizol Corporation): 3.0 parts by mass
   - Dispersion medium: 70.8 parts by mass of dipropylene glycol diacrylate

### (Preparation of cyan pigment dispersion liquid C)

A cyan pigment dispersion liquid C was prepared in the same manner as the yellow pigment dispersion liquid Y except that the type and amount of the dispersing agent used and the amount of the dispersion medium were changed as shown below, and the pigment added was changed to 23.0 parts by mass of cyan pigment PB15:4 (Chromaffin Blue 6332JC, manufactured by Dainichiseika Color & Chemicals Mfg. Co., Ltd.).
- Pigment-dispersing agent 1 (manufactured by Basf SE, PX4701): 7.0 parts by mass
- Dispersion medium: 70.0 parts by mass of dipropylene glycol diacrylate

The above-described yellow pigment and cyan pigment are pigments that have been subjected to a water washing treatment to reduce the amount of impurities (conductive materials and ionic impurities).

### 2. Inkjet ink preparation

### (Inkjet ink 1)

4.67 parts by mass of the yellow pigment dispersion liquid Y and 2.17 parts by mass of the cyan pigment dispersion liquid C were mixed, and the following materials were added to the obtained mixed liquid while stirring the mixed liquid to prepare an ink composition.

### < Active ray polymerizable compound >

- Compound A-3: 10.0 parts by mass
- Amine-modified oligomer 1: 5.0 parts by mass
- Dipropylene glycol diacrylate (DPGDA): 45.7 parts by mass
- Trimethylolpropane PO-modified triacrylate (TMP (PO) 3TA):
   30.0 parts by mass

### < Polymerization initiators >

- Initiator 1: 3.0 parts by mass
- Initiator 2: 3.0 parts by mass
- Initiator 3: 2.0 parts by mass

### < Polymerization inhibitor >

- Irgastab UV-10 (manufactured by BASF): 0.1 parts by mass

The obtained ink composition was filtered through a 3.0-µm membrane filter (manufactured by ADVANTECH) to obtain inkjet ink 1.

Inkjet inks 2 to 14 were obtained in the same manner as the inkjet ink 1 except that the materials and amounts used were changed to obtain the ink compositions as shown in Tables 1 and 2.

### 3. Formation of cured product

Each of the prepared inks was loaded into an inkjet recording apparatus having an inkjet recording head provided with a piezo-type inkjet nozzle. Next, a voltage was applied to the inkjet recording head such that the amount of ejected droplets became 6.0 pL, thereby forming the following two patterns on the copper-clad laminate for a printed wiring board (FR-4, 1. 6 mm thick, 150 mm × 95 mm large): a 20 mm × 50 mm, 30 µm-thick solid pattern, and a 30 µm-thick comb-shaped thin line pattern with a line and space of 100 µm. At the time of pattern formation, the ink in the inkjet recording head was heated to 80°C with a built-in heater of the recording head.

The printed pattern was irradiated with ultraviolet rays using an LED lamp (Fire Jet (TM) FJ100, manufactured by Phoseon Technology, Inc., wavelength 395 nm) so that the intensity became 500 mJ/cm² to cure the ink layer. For the patterns formed using the inkjet ink 3 to 8 and the inkjet ink 10 to 14, the copper-clad laminate on which the pattern was formed was placed in an oven set at 150°C and heated for 60 minutes to further cure the ink layer.

### 4. Evaluation

### (Adhesion)

The obtained cured product of the solid pattern was cut in a grid pattern in accordance with the cross-cut method of JIS K5600-5-6:1999, and an adhesive tape was attached thereto. The adhesive tape was peeled off, and the state of peeling of the cured film from the substrate was observed to determine the adhesive residue rate. Here, the adhesive residue rate refers to a ratio of the number of squares in which the cured film remains after the tape is peeled off to the number of squares formed by making the cuts. Based on the adhesive residue rate, evaluation of adhesion was performed according to the following evaluation criteria.
⊚ The adhesive residue rate is 100%
∘ The adhesive residue rate is 80% or more and less than 100%
△ The adhesive residue rate is 60% or more and less than 80%
× The adhesive residue rate is less than 60%

### (Ion migration)

A DC voltage of 50 V was applied to the obtained cured product of the fine line pattern using an insulation resistance measuring device (ECM-100, manufactured by J-RAS Inc) under an environment of a temperature of 85°C and a relative humidity of 85%, and the cured product was allowed to stand for 500 hours. Thereafter, the insulation resistance measuring device value was read, and the electric resistance value (Ω) of the cured product was measured. Ion migration was evaluated according to the following criteria on the basis of the measured electric resistance value.
⊚⊚ The electric resistance value is 1.0 × 10¹² Ω or more
⊚ The electric resistance value is 1.0 × 10¹¹ Ω or more and less than 1.0 × 10¹² Ω
∘ The electric resistance value is 1.0 × 10¹⁰ Ω or more and less than 1.0 × 10¹¹ Ω
△ The electric resistance value is 1.0 × 10⁸ Ω or more and less than 1.0 × 10¹⁰ Ω
× An electric resistance value is less than 1.0 × 10⁸ Ω

### (Chloride ion content)

Each inkjet ink was charged into a combustion flask to combust the ink sample. The generated gas was absorbed in aqueous hydrogen peroxide, and the absorption liquid was analyzed by ion chromatography to determine the chloride ion content [ppm].

### (Insulating properties)

For the obtained cured product of the solid pattern, the electric resistance value R was measured by a method in accordance with the electrical property test of JISC 5012: 1993.

The evaluation results are summarized in Tables 1 and 2.

**[Table 1]**

| | | | Example 1 | Example 2 | Example 3 | Example 4 | Example 5 | Example 6 | Example 7 | Example 8 | Example 9 |
|---|---|---|---|---|---|---|---|---|---|---|---|
| Ink No | | | 1 | 2 | 3 | 4 | 5 | 6 | 7 | 8 | 9 |
| Active ray polymerizable compound | Carboxyl group-containing | Carboxyethyl acrylate | | | | | | 10.0 | | 10.0 | |
| | | A-1 | | | | 10.0 | | | | | |
| | | A-2 | | | | | 10.0 | | | | |
| | | A-3 | 10.0 | 10.0 | 10.0 | | | | 10.0 | | 10.0 |
| | Hydroxyl group-containing acrylate | | | | | | | | | | |
| | Amine-modified oligomer | 1 | 5.0 | | | | | | 5.0 | 5.0 | 5.0 |
| | | 2 | | 5.0 | 5.0 | 5.0 | 5.0 | 5.0 | | | |
| | Others | DPGDA | 45.7 | 45.7 | 45.7 | 45.7 | 45.7 | 45.7 | 44.7 | 44.7 | 44.7 |
| | | TMP(PO)3TA | 30.0 | 30.0 | 30.0 | 30.0 | 30.0 | 30.0 | 30.0 | 30.0 | 30.0 |
| Gelling agent | | | | | | | | | 1.0 | 1.0 | 1.0 |
| Polymerization initiator | Initiator 1 | | 3.0 | 3.0 | 3.0 | 3.0 | 3.0 | 3.0 | 3.0 | 3.0 | 3.0 |
| | Initiator 2 | | 3.0 | 3.0 | 3.0 | 3.0 | 3.0 | 3.0 | 3.0 | 3.0 | 3.0 |
| | Initiator 3 | | 2.0 | 2.0 | 2.0 | 2.0 | 2.0 | 2.0 | 2.0 | 2.0 | 2.0 |
| Polymerization inhibitor | | | 0.1 | 0.1 | 0.1 | 0.1 | 0.1 | 0.1 | 0.1 | 0.1 | 0.1 |
| Pigment | Yellow pigment | | 0.7 | 0.7 | 0.7 | 0.7 | 0.7 | 0.7 | 0.7 | 0.7 | 0.7 |
| | Cyan pigment | | 0.5 | 0.5 | 0.5 | 0.5 | 0.5 | 0.5 | 0.5 | 0.5 | 0.5 |
| Total | | | 100.0 | 100.0 | 100.0 | 100.0 | 100.0 | 100.0 | 100.0 | 100.0 | 100.0 |
| Curing method | | UV | ○ | ○ | | | | | | | ○ |
| | | UV + heating | | | ○ | ○ | ○ | ○ | ○ | ○ | |
| Evaluation method | | Adhesion | ⊚ | ⊚ | ⊚ | ⊚ | ⊚ | ○ | ⊚ | ○ | ⊚ |
| | | Ion migration | ○ | ○ | ⊚ | ⊚ | ⊚ | ⊚ | ⊚⊚ | ⊚⊚ | ⊚ |
| | | Chloride ion amount [ppm] | <5 | <5 | <5 | <5 | <5 | <5 | <5 | <5 | <5 |
| | | Electric resistance value R [Ω] | R ≥ 1.0× 10⁸ | R ≥ 1.0× 10⁸ | R ≥ 1.0× 10⁸ | R ≥ 1.0× 10⁸ | R ≥ 1.0× 10⁸ | R ≥ 1.0× 10⁸ | R ≥ 1.0× 10⁸ | R ≥ 1.0× 10⁸ | R ≥ 1.0× 10⁸ |

**[Table 2]**

| | | | Comparative example 1 | Comparative example 2 | Comparative example 3 | Comparative Example 4 | Comparative example 5 |
|---|---|---|---|---|---|---|---|
| Ink No | | | 10 | 11 | 12 | 13 | 14 |
| Active ray polymerizable compound | Carboxyl group-containing | carboxyethyl acrylate | | 10.0 | | | |
| | | A-1 | | | | | |
| | | A-2 | | | | | |
| | | A-3 | | | 10.0 | 0.0 | 10.0 |
| | Hydroxyl group-containing acrylate | | 10.0 | | | | |
| | Amine-modified oligomer | 1 | | | | | |
| | | 2 | 5.0 | | | | |
| | Amine-modified monomer | | | | | 5.0 | |
| | Others | DPGDA | 45.7 | 50.7 | 49.7 | 43.7 | 43.7 |
| | | TMP(PO)3TA | 30.0 | 30.0 | 31.0 | 32.0 | 32.0 |
| Amine compound (no polymerizable group) | | | | | | | 5.0 |
| Gelling agent | | | | | | | |
| Polymerizatio n initiator | Initiator 1 | | 3.0 | 3.0 | 3.0 | 3.0 | 3.0 |
| | Initiator 2 | | 3.0 | 3.0 | 3.0 | 3.0 | 3.0 |
| | Initiator 3 | | 2.0 | 2.0 | 2.0 | 2.0 | 2.0 |
| Polymerization inhibitor | | | 0.1 | 0.1 | 0.1 | 0.1 | 0.1 |
| Pigment | Yellow pigment | | 0.7 | 0.7 | 0.7 | 0.7 | 0.7 |
| | Cyan pigment | | 0.5 | 0.5 | 0.5 | 0.5 | 0.5 |
| Total | | | 100.0 | 90.0 | 100.0 | 100.0 | 100.0 |
| Curing method | | UV | | | | | |
| | | UV + heating | ○ | ○ | ○ | ○ | ○ |
| Evaluation method | | Adhesion | Δ | ○ | ⊚ | ⊚ | ⊚ |
| | | Ion migration | Δ | × | × | × | × |
| | | Chloride ion amount [ppm] | <5 | <5 | <5 | <5 | <5 |
| | | Electric resistance value R [Ω] | R ≥ 1.0× 10⁸ | R ≥ 1.0× 10⁸ | R ≥ 1.0× 10⁸ | R ≥ 1.0× 10⁸ | R ≥ 1.0× 10⁸ |

The results of examples 1 to 9 indicate that an ink composition containing an active ray polymerizable compound that has a carboxyl group and containing an amine-modified oligomer had enhanced adhesion to the copper substrate and inhibited a reduction in insulating properties due to ion migration.

Furthermore, since the active ray polymerizable compound having a carboxyl group was the compound represented by the general formula (1), the adhesion to the copper substrate was further enhanced.

In addition, when an ink composition contained the gelling agent, a decrease in insulating properties due to ion migration was further suppressed.

This application claims the benefit of Japanese Patent Application No. 2023-077161 filed on May 9, 2023. The contents described in the specification of the application and the drawings are all incorporated in the description of the present application.

### Industrial Applicability

According to the active ray curable inkjet ink composition of the present invention, it is possible to form an insulating film that has sufficiently increased adhesion to metal and can prevent a reduction in insulating properties in a high-humidity environment. Therefore,
the present invention is useful for an electronic member (e.g., a circuit board).

## Claims

1. An active ray curable inkjet ink composition comprising an active ray polymerizable compound, wherein:
the active ray polymerizable compound includes an active ray polymerizable compound that has a carboxyl group and an amine-modified oligomer that has no carboxyl group; and
the active ray curable inkjet ink composition is used for forming an insulating film on an electronic member.

2. The active ray curable inkjet ink composition according to claim 1, further comprising a gelling agent.

3. The active ray curable inkjet ink composition according to claim 1, wherein the active ray polymerizable compound having a carboxyl group is a compound represented by a general formula (1): 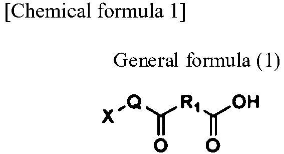 in the general formula (1), R₁ represents an unsubstituted alkylene group having 1 or more and 6 or less carbon atoms, Q represents an oxygen atom or NR₂, R₂ represents a hydrogen atom, a substituted or unsubstituted alkyl group, or a substituted or unsubstituted aryl group, X represents a structure derived from an alcohol or an amine, and X has, at a terminal thereof, at least one polymerizable group selected from the group consisting of a (meth)acryloyl group, an aryl group, and a vinyl group.

4. The active ray curable inkjet ink composition according to claim 3, wherein, in the general formula (1), X has a (meth)acryloyl group at the terminal thereof.

5. The active ray curable inkjet ink composition according to claim 3, wherein, in the general formula (1), Q represents an oxygen atom.

6. The active ray curable inkjet ink composition according to claim 3, wherein, in the general formula (1), R₁ represents an unsubstituted alkylene group having 1 or 2 carbon atoms.

7. A method for forming an insulating film, the method comprising:
applying the active ray curable inkjet ink composition according to any one of claims 1 to 6 to a metal surface of an electronic member; and
irradiating the applied active ray curable inkjet ink composition with an active ray to cure the active ray curable inkjet ink composition.

8. The method according to claim 7, further comprising heating the active ray curable inkjet ink composition having been irradiated with the active ray.

9. An insulating film formed by irradiating the active ray curable inkjet ink composition according to any one of claims 1 to 6 with an active ray and optionally heating the active ray curable inkjet ink composition after the irradiating with the active ray.

10. A printed wiring board comprising the insulating film according to claim 9.
